# EUROPEAN PATENT SPECIFICATION

(11) **EP 0 867 924 B1**
(45) Date of publication and mention of the grant of the patent: **31.08.2011**
(21) Application number: 98870026.6
(22) Date of filing: 10.02.1998
(51) Int. Cl.: H01L 21/306, H01L 21/311, G03F 7/42

(54) **Method for removing organic contaminants from a semiconductor surface**
Verfahren zur Entfernung organischer Kontamination von einer Halbleiteroberfläche
Procédé pour enlever la contamination organique de la surface de semiconducteurs

(30) Priority: 14.02.1997 US 40309 P; 25.03.1997 US 42389 P; 20.11.1997 US 66261 P
(43) Date of publication of application: 30.09.1998
(73) Proprietor: IMEC, 3001 Leuven (BE)
(72) Inventor: De Gendt, Stefan, 2110 Wijnegem (BE); Snee, Peter, 3001 Veltem-Beisem (BE); Heyns, Marc, 3210 Linden (BE)
(74) Representative: Van Malderen, Joëlle

(56) References cited:
- EP-A- 0 327 263
- EP-A- 0 548 596
- EP-A- 0 702 399
- GB-A- 2 287 827
- JP-A- 07 297 163
- US-A- 4 974 530
- US-A- 5 503 708
- PATENT ABSTRACTS OF JAPAN vol. 010, no. 141 (E-406), 24 May 1986 & JP 61 004232 A (NIPPON DENKI KK), 10 January 1986
- SEHESTED K ET AL: "Decomposition of Ozone in Aqueous Acetic Acid Solutions (pH 0-4)" JOURNAL OF PHYSICAL CHEMISTRY, vol. 96, 1992, pages 1005-1009, XP002108237
- Hawley: "Hawley's Condensed Chemical Dictionary", 1987, Van Nostrand Reinhold Company, New York ISBN: 0442280971 pages 1028-1028,

## Description

### Object of the invention

The present invention is related to a method for removing organic contaminants from a semiconductor surface.

The present invention is also related to the use of this method for specific applications such as VIA etching.

### Background of the invention

The semiconductor surface preparation prior to various processing steps such as oxidation, deposition or growth processes, has become one of the most critical issues in semiconductor technology. With the rapid approach of sub halfmicron design rules, very small particles and low levels of contamination or material impurities (~10¹⁰ atoms/cm² and lower) can have a drastic effect on process yields. The contaminants that are to be removed from a semiconductor surface include metallic impurities, particles and organic material. A commonly used technique to reduce foreign particulate matter contamination level on semiconductor surfaces, is the immersion of wafers in chemical solutions.

Organic material is one of the contaminants that has to be removed from the semiconductor wafer surface. In a pre-clean stage, absorbed organic molecules prevent cleaning chemicals from contacting with the wafer surface, thus leading to non-uniform etching and cleaning on the wafer surface. In order to realize contamination free wafer surfaces, organic impurities have to be removed before other wafer cleaning processes. Traditional wet cleaning processes involve the use of sulfuric peroxide mixtures (SPM) to remove organic molecules. However, SPM uses expensive chemicals and requires high processing temperatures, and causes problems in terms of chemical waste treatment.

Other sources of organic contamination also arise during a standard IC process flow. Such sources can be photoresist layers or fluorocarbon polymer residues that are deposited on a substrate.

The fluorocarbon residues originate from the exposure of semiconductor (silicon) substrates to dry oxide etch chemistries. In conventional oxide etching with fluorocarbon gases, an amount of polymer is intentionally generated in order to achieve a vertical sidewall profile and better etch selectivity to the photoresist mask and underlying film. Etch selectivity in a SiO₂-Si system can be achieved under certain process conditions through the formation of fluorocarbon based polymers. The polymerisation reaction occurs preferably on Si, thus forming a protective coating and etch selectivity between Si and SiO₂. After selective etching, both resist and polymer-like residue must be removed from the surface. If the polymer is not completely removed prior to the subsequent metal deposition, the polymer will mix with sputtered metal atoms to form a high resistance material resulting in reliability concerns. Methods of polymer removal depend on the plasma etch chemistry, plasma source and the composition of the film stack. However, for dry processes, the application of O2 or H2 containing gases have been applied to remove the fluorocarbon polymers. For wet cleaning techniques an amine based solvent (US-A-5 279 771 and US-A-5 308 745) is frequently applied. Organic photoresist removal generally involves wet or dry oxidative chemistries (i.e. O2 plasma, SPM) or dissolution processes based on solvent strippers. These processes are both expensive and environmentally harmful in terms of waste treatment.

In an attempt to find alternative efficient cleans for the removal of organic contamination (including photoresist and etch residues) from Si surfaces, the use of ozonated chemistries has been investigated. Ozone has been used extensively in the field of waste water treatment and drinking water sterilisation, because of its strong oxidising power. An additional benefit of ozone is its harmless residue after decomposition and/or reaction (H₂O, CO₂, O₂). It is generally presumed that oxidative action of ozone towards organic contamination involves two different oxidation pathways, either direct oxidation or advanced oxidation. Direct oxidation or ozonolysis involves molecular ozone as the prime oxidant. It predominantly occurs at carbon-carbon double bonds. This type of oxidation is favored in the low pH region of the waste water. Advanced oxidation involves secondary oxidants as the prime oxidant (e.g. OH radicals). This type of oxidation is more reactive, but less sensitive and is predominant at conditions that favor OH radical formation, such as high pH, elevated temperature, addition of enhancers (e.g. H₂O₂), UV radiation. In real life situations one often deals with a mixture of contaminants having a different reactivity towards ozone. However, both oxidation pathways are concurrent and conditions that favor advanced oxidation pathways will occur at the expense of the efficiency of eliminating organic contamination with higher reactivity towards molecular ozone. In order to optimize the organic removal efficiency of ozonated chemistries, it is critical to identify the parameters that influence both oxidation pathways.

In recent years, ozone was introduced in the microelectronics industry because of its strong oxidizing capabilities. When ozone gas is dissolved into water, its self-decomposition time gets shorter compared to the gaseous phase. During self-decomposition, ozone generates OH radicals as a reaction by-product, which is according to G.Alder and R.Hill in J.Am.Chem.Soc. 1950, 72 (1984) believed to be the reason for decomposition of organic material.

Document US-A-5 464 480 describes a process for removing organic material from semi-conductor wafers. The wafers are contacted with a solution of ozone and water at a temperature between 1° and 15°C. Wafers are placed into a tank containing deionized water, while diffusing ozone into the (sub-ambient) deionized water for a time sufficient to oxidize the organic material from the wafer, while maintaining the deionized water at a temperature of about 1° to about 15°C, and thereafter rinsing the wafers with deionized water. The purpose of lowering the temperature of the solution to a range between 1° and 15° C is to enable sufficiently high ozone concentrations into water to oxidize all of the organic material onto the wafer into insoluble gases.

Document EP-A-0508596 describes a spray-tool process, whereby during the cleaning process, various liquid chemicals, ultra-pure water or a mixed phase fluid comprising an ozone-containing gas and ultra pure water are sprayed onto substrates or semiconductor wafers in a treating chamber filled with ozone gas. Rotation is necessary to constantly renew thin films of treating solution and promoting removal of undesired materials by means of centrifugal force.

Document US-A-5 181 985 describes a process for the wet-chemical surface treatment of semiconductor wafers in which aqueous phases containing one or more chemically active substances in solution act on the wafer surface, consisting of spraying a water mist over the wafer surface and then introducing chemically active substance in the gaseous state so that these gaseous substances are combined with the water mist in order to have an interaction of the gas phase and the liquid phase taking place on the surface of the semiconductor wafers. The chemical active substance are selected from the group consisting of gases of ammonia, hydrogen chloride, hydrogen fluoride, ozone, ozonized oxygen, chlorine and bromine. The water is introduced into the system at a temperature of 10°C to 90°C.

Document US-A-5 503 708 describes a method and an apparatus for removing a organic film wherein a mixed gas including an alcohol and one of ozone gas and an ozone-containing gas is supplied into the processing chamber at least for a period before that the semiconductor wafer is placed in said processing chamber so that the mixed gas will act on the organic film formed on the surface of the semiconductor wafer.

Document JP-A-61004232 is describing a cleaning method of semiconductor substrates. The method is presented as an alternative for traditional acid-hydrogen peroxide cleans, which in the prior art are used for heavy metal reduction on silicon wafers. Substrates are dipped in a solution of an undiluted organic acid, e.g. formic acid or acetic acid filled into a cleaning tank wherein ozone or oxygen is supplied from the bottom of the tank so as to bubble into the solution, said solution being heated to a temperature comprised between 100°C to 150°C. Organic waste matter is oxidized by means of the ozone and can be dissolved and removed. In other words, this Japanese publication describes cleaning of heavy metals on semiconductor wafers through formation of metal formate or metal acetate compounds and of dissolving the organic waste matter from semiconductor wafers by means of ozone.

### Aims of the present invention

The present invention aims to suggest an improved method for the removal of organic contaminants from a semiconductor substrate.

More particularly, the present invention aims to suggest a method of removal of organic contamination such as photoresist, photoresidue, dry etched residue which can occur in any process step of the fabrication of semiconductor substrate.

### Summary of the present invention

The present invention is related to a method according to the appended claims of removing organic contaminants from a substrate comprising the steps of holding said substrate in a tank, filling said tank with a gas mixture comprising water vapor, ozone and an additive acting as a scavenger.

By scavenger, it is meant a substance added to a mixture or any other systems such as liquid, gas, solution in order to counteract the unwanted effects of other constituents of the mixture or system.

Said additive acts as a OH radical scavenger. A radical is an uncharged species (i.e. an atom or a di-atomic or poly-atomic molecule) which possesses at least one unpaired electron. Examples of scavenger can be carboxylic or phosphonic acid or salts thereof such as acetic acid (CH₃COOH), and acetate (CH3COO⁻) as well as carbonate (HₓCO₃^{-(2-x)}) phosphate (HₓPO4^{-(3-x)}).

The invention can be used in the fabrication of silicon wafers for Integrated Circuits. The invention can also be used in related fields, like the fabrication of flat panel displays, solar cells, or in micro-machining applications or in other fields wherein organic contaminants have to be removed from substrates.

### Brief description of the drawings

***Figure 1*** is a schematic representation of a deep VIA etch structure.
***Figure 2*** is a schematic representation of an Al overetched VIA structure.
***Figure 3*** is a representation of the experimental set-up used in the gas phase processing.
***Figure 4*** is representing a SEM micrograph of via structure prior to any cleaning treatment.
***Figure 5*** represents a SEM micrograph of a VIA structure after 45' 02 dry strip.
***Figure 6*** represents SEM micrograph of a deep VIA as represented in figure 1 after 10' exposure to a preferred embodiment of the method of the present invention.
***Figure 7*** represents an SEM micrograph of Al overetched via according to figure 2 after 10' exposure to a preferred embodiment of the method of the present invention.
***Figure 8*** is representing the experimental set-up of the liquid phase processing.
***Figure 9*** represents the resist removal process efficiency number for positive and negative resist removal as a function of the acetic acid concentration.
***Figure 10 & 11*** represent the main parameter effects on resist removal rate and resist removal process efficiency number for positive resist removal.
***Figure 12*** represents the resist removal efficiency as a function of the temperature and the ozone concentration in a static system.
***Figure 13*** represents the resist removal efficiency as a function of the temperature and ozone concentration in bubble or moist gasphase processing.
***Figure 14*** represents a possible scheme of reactions in an aqueous ozone.
***Figure 15*** represents the effect of OH radical scavenging on ozone concentration in an overflow tank.
***Figure 16*** represents the effect of repeated addition of hydrogen peroxide to a de-ionised water solution spiked with acetic acid.

### Detailed description of several embodiments of the present invention

The purpose of the present invention is related to a method for removing organic contamination from a substrate. Said substrate can be a semiconductor surface.

Said method can be applied for the removal of photoresist and organic post-etch residues from silicon surfaces. Said organic contamination can be confined in a layer covering at least part of said substrate. Said layer can have a thickness in a range of submonolayer coverage to 1 µm. Said method is applicable for gasphase processes.

In the following specification, a preferred embodiment of the invention for gas phase processing is described.

### Description of a preferred embodiment for gasphase processing

In said gasphase process, said substrates are placed in a tank such that said substrates are in contact with a gas mixture containing water vapor, ozone and an additive acting as a scavenger.

Said scavenger is a substance added to said mixture to counteract the unwanted effects of other constituents. Said scavenger typically acts as an OH radical scavenger. Said additive can be a carboxylic or a phosphonic acid or salts thereof. More preferably, said additive is acetic acid.

The proportion of said additive in said gas mixture is preferably less than 10% molar weight of said gas mixture. The proportion of said additive in said gas mixture is more preferably less than 1% molar weight of said gas mixture. Even more preferably, the proportion of said additive in said gas mixture is less than 0.5% molar weight of said gas mixture. Even more preferably, the proportion of said additive in said gas mixture is less than 0.1% molar weight of said gas mixture.

Said gas mixture can also contain oxygen, nitrogen, argon or any other inert gas. The ozone concentration of said gas mixture is typically below 10% molar weight. The water vapor is typically saturated at the operational temperature of said mixture. The operational temperature of said mixture is below 150°C and higher than the temperature of said substrate.

Said method also comprises a step of rinsing said substrate with a solution. Said rinsing solution comprises preferably de-ionized water. Said rinsing solution can further comprise HCl and/or HF and/or HNO3 and/or CO2 and/or O3. Said rinsing solution can also be subjected to megasone agitation.

According to a preferred embodiment, the method can also comprise the step of filling said tank with a liquid comprising essentially water and said additive, the liquid level in said tank remaining below the substrate and wherein said liquid is heated. Said tank is then filled with a saturated water vapor containing said additive. Said tank is further filled with ozone. According to a preferred embodiment, the ozone can be bubbled through said liquid. Preferably, said liquid is heated in a range between 16°C and 99°C and even more preferably between 20°C and 90°C. Even more preferably, the liquid is heated between 60°C and 80°C.

According to the best mode embodiment, the set-up denoted as moist ozone gasphase process uses a quartz container filled with only a minute amount of liquid, sufficient to fully immerse a O₃ diffuser. The liquid is DI water, spiked with an additive, such as acetic acid. A lid is put on the quartz container. The liquid is heated to 80°C. Wafers are placed directly above the liquid interface but are not immersed. The ozone diffusor is fabricated from fused silica, and the ozone generator (Sorbius) is operated with an oxygen flow which maximizes the ozone content in the gas flow. In the best mode embodiment, a flow of 3 l/min O₂ is used. At all time the ozone is bubbled directly into the liquid (no bubble reduction) throughout the experiment. Heating of the liquid in a sealed container and continuous O₃ bubbling through the liquid exposes the wafers to a moist O₃ ambient. In the gasphase experiment, operational temperature was 80°C, while the DI water is acidified (1/100 volume ratio) with acetic acid. Wafers are to be processed sufficiently long and a rinse step follows the moist gas phase treatment. In an embodiment, wafers are processed for 10 minutes, and subsequently rinsed in DI water for 10 minutes.

### Description of a method for liquid processing

In said liquid process, which is not part of the claimed invention, said substrates are placed in a tank such that said substrates are in contact with a liquid mixture comprising water, ozone and an additive acting as a scavenger. Said scavenger is a substance added to said mixture to counteract the unwanted effects of other constituents. Said scavenger typically acts as an OH radical scavenger.

Said additive can be a carboxylic or a phosphonic acid or salts thereof, preferably said additive is acetic acid. The proportion of said additive in said liquid is less than 1% molar weight of said liquid. Preferably, the proportion of said additive is said liquid is less than 0.5 molar weight of said liquid. More preferably, the proportion of said additive in said liquid is less than 0.1% molar weight of said liquid.

Said liquid can also be subjected to megasone agitation.

The method for liquid processing also comprises a step of maintaining said liquid at a temperature less than the boiling point of said liquid. Preferably, the temperature of said liquid is lower than 100°C. More preferably, the temperature of said liquid is comprised between 16°C and 99°C. More preferably, the temperature of said liquid is comprised between 20°C and 90°C. Even more preferably, the temperature of said liquid is comprised between 60°C and 80°C.

Preferably, the ozone is bubbled through the said liquid which allows a contact of the bubbles of ozone with the substrates.

Said method also comprises a step of rinsing said substrate with a rinsing solution. Preferably, said rinsing solution comprises de-ionized water. More preferably, said rinsing solution further comprises HCl and/or HF and/or HNO₃ and/or CO₂ and/or O₃. Said rinsing solution can also be subjected to megasone agitation.

According to the best mode example of the method, the following set-up is used: The O₃ set-up (immersion based), denoted as bubble experiment, consists of a quartz container holding 7 litres of a liquid and an ozone diffuser located at the bottom of the tank. The liquid can be heated. Operational temperature is 45°C. The ozone diffusor is fabricated from fused silica, and the ozone generator (Sorbius) is operated with an oxygen flow which maximizes the ozone content in the gas flow. In the best mode embodiment, a flow of 3 l/min O₂ is used. At all time the ozone is bubbled directly into the quartz tank (no bubble reduction) throughout the experiment. The substrates are positioned directly above the ozone diffuser, and immersed in the liquid. As such O₂/O₃ bubbles contact the surface. The substrates are exposed to an ozone treatment with varying acetic acid concentrations in the bubble set-up . The substrates are exposed to an ozone clean between 0-11,5 mol/l (0, 0.1ml (0.46mmol/l), 1.0ml (2.3mmol/l) and 5.0ml (11.5mmol/l)) of acetic acid added to the 7 liter of DI water.

### Application 1: VIA CLEANING

The method of the present invention can be applied for wafer cleaning technologies after plasma etching processes especially into submicron processes. Dry etching of silicon and its compounds is based on the reaction with fluorine, with resulting fluorocarbon polymer contamination. The fluorocarbon residues originate from the exposure of semiconductor (silicon) substrates to dry oxide etch chemistries. In conventional oxide etching with fluorocarbon gases, an amount of polymer is intentionally generated in order to achieve a vertical sidewall profile and better etch selectivity to the photoresist mask and underlying film. Etch selectivity in a SiO₂-Si system can be achieved under certain process conditions through the formation of fluorocarbon based polymers.

The polymerisation reaction occurs preferably on Si, thus forming a protective coating and etch selectivity between Si and SiO₂. After selective etching, both resist and polymer-like residue must be removed from the surface. If the polymer is not completely removed prior to the subsequent metal deposition, the polymer will mix with sputtered metal atoms to form a high resistance material resulting in reliability concerns. Methods of polymer removal depend on the plasma etch chemistry, plasma source and the composition of the film stack. However, for dry processes, O₂ or H₂ containing gases have been applied to remove the fluorocarbon polymers. For wet cleaning techniques an amine based solvent US-A-5 279 771 and US-A-5 308 745 is frequently applied. These processes are frequently both expensive and environmentally harmful in terms of waste treatment.

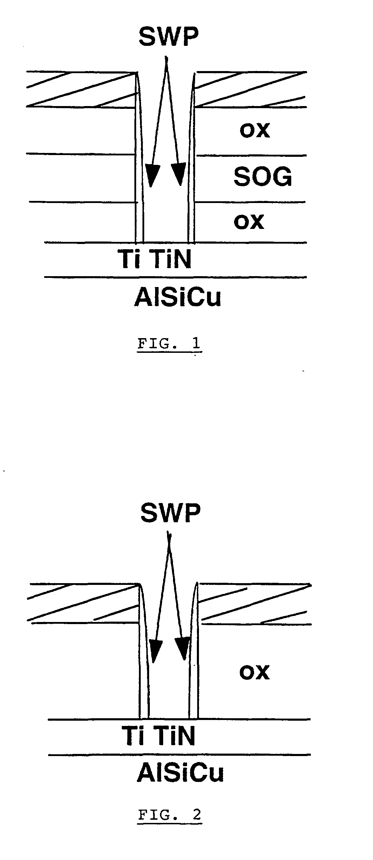

Figures 1 and 2 shows different VIA test structures prepared on p-type wafers. The first structure consists of 500 nm oxide, 30/80 nm Ti/TiN, 700 nm AlSiCu, 20/60 nm Ti/TiN, 250 nm oxide, 400 nm SOG and 500 nm oxide (starting from the silicon substrate). The second structure contains the following layers; 500 nm oxide, 30/80 nm Ti/TiN, 700 nm AlSiCu, 20/60 nm Ti/TiN and 500 nm oxide (also starting from the silicon substrate). Subsequently, these structures are coated with I-line resist and exposed through a mask set with contact holes ranging from 0.4µm till 0.8µm in diameter. VIA's were etched in a CF4/CHF3 plasma. For the first set of wafers VIA's are etched through the 500 nm oxide / 400 nm SOG / 250 nm oxide, stopping on TiTiN/Al, for the second set of wafers, VIA's are overetched through the 500 nm oxide layer into the TiTiN/Al layers. Wafers are exposed to the ozone clean directly (i.e. with resist layer and sidewall polymers on the wafer).

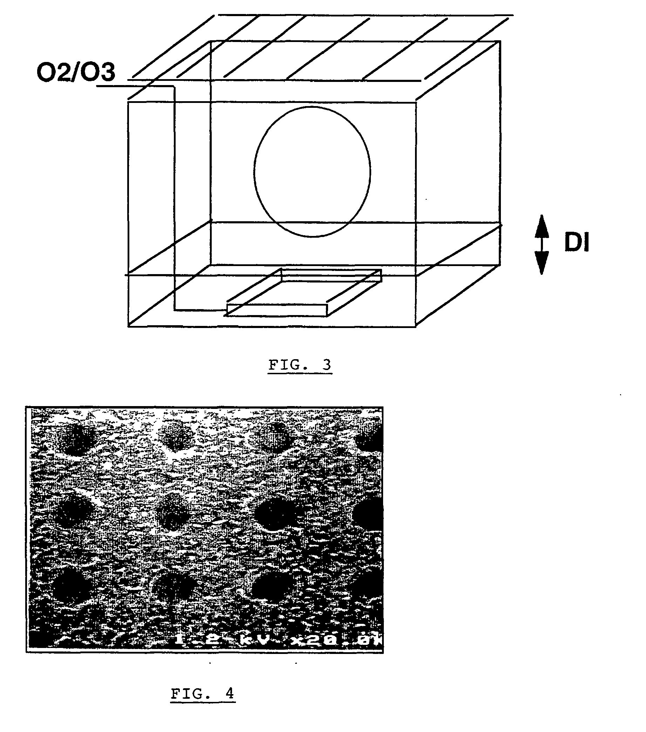

The set-up used for this application is represented in Figure 3. The set-up denoted as moist ozone gasphase process uses a quartz container filled with only a minute amount of liquid, sufficient to fully immerse a O₃ diffuser. The liquid is DI water, spiked with an additive, such as acetic acid. A lid is put on the quartz container. The liquid is heated to 80°C. Wafers are placed directly above the liquid interface but are not immersed. The ozone diffusor is fabricated from fused silica, and the Sorbius generator is operated with a flow of 31/min O₂ flow. At all time the ozone is bubbled directly into the quartz tank (no bubble reduction) throughout the experiment. Heating of the liquid in a sealed container and continuous O₃ bubbling through the liquid exposes the wafers to a moist O₃ ambient. In the gasphase experiment, operational temperature was 80°C, while the DI water is acidified (1/100 volume ratio) with acetic acid. In all cases, wafers are processed for 10 minutes, and subsequently rinsed in DI water for 10 minutes.

Quarter wafers are used, as such, the exact same wafer is used for all treatments; facilitating relative comparison of the cleaning efficiencies of either process. Cleaning efficiency is evaluated from SEM measurements (on 0.6µm VIA's) . For reference, wafers were also dry stripped for 45 minutes during an O2 plasma treatment (i.e. leaving sidewall polymers on the wafer).

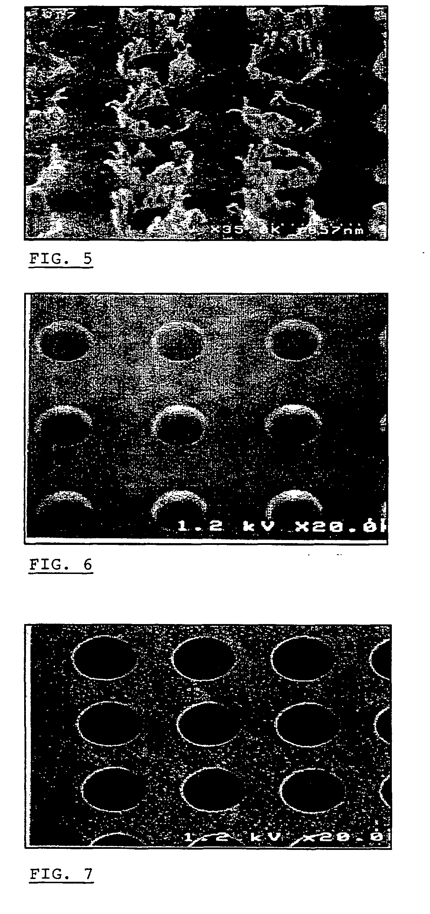

Figure 4 shows SEM micrograph of VIA structures (Figure 1) prior to exposure to any cleaning treatment, i.e. with resist and side-wall polymers present. Figure 5 is a SEM micrograph of VIA structure in Figure 1 after 45' O2 dry strip. SEM micrographs for both structures in Figure 1 and 2, after 10' exposure to the optimized moist ozone gasphase process with acetic acid addition, are shown in Figure 6 and 7 respectively.

It can be seen immediately that after 45' O2 dry strip treatment side wall polymers are still clearly visible. However, if we consider the gasphase experiment, we do observe an excellent cleaning efficiency (Figure 6 and 7). Note that identical wafers and process times were used for all ozone experiments, making the effect even more significant. In the gasphase experiment resist coating as well as sidewall post-etch polymer residues are no longer observed on the surface.

Moist ozone gasphase treatment with acetic acid spiking has been demonstrated to be efficient in removing both resist layers and sidewall polymer residues from VIA-etched wafers. This is due to both physical and chemical enhancement of the ozone efficiency for removal of organic contamination.

### Application 2: Resist removal

As indicated hereabove, chemical additives such as acetic acid can have have impact on the removal efficiency of organic contamination by means of ozonated chemistries. For this purpose, wafers coated with a resist layer are exposed to various ozonated DI water mixtures. The resist removal efficiency is evaluated. Wafers are coated with positive (IX500el from JSR electronics) and negative (UVNF from Shipley) resist. The resist covered wafers are given a DUV bake treatment to harden the resist prior to use. Also implanted wafers (5e13at/cm2 P) with positive resist are processed. Resist thickness is monitored ellipsometrically before and after the process.

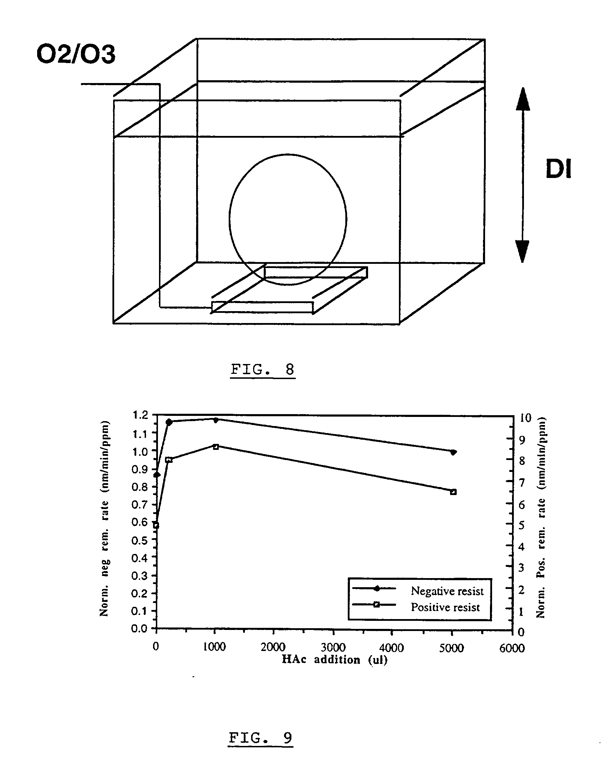

The O₃ reference set-up (immersion based) used for another specific application denoted as bubble experiment is represented in Figure 8, consist of a quartz container holding 7 litre of a liquid and an ozone diffuser located at the bottom of the tank. The liquid can be heated. Operational temperature is 45°C. The ozone diffusor is fabricated from fused silica, and the Sorbius generator is operated with a flow of 3l/min O₂ flow. At all time the ozone is bubbled directly into the quartz tank (no bubble reduction) throughout the experiment. Wafers are positioned directly above the ozone diffuser, and immersed in the liquid. As such O₂/O₃ bubbles contact the surface. The wafers are exposed to an ozone treatment with varying acetic acid concentrations in the bubble set-up shown in Figure 7. The unimplanted resist wafers are exposed to an ozone clean with 0, 0.1ml (0.46mmol/l), 1.0ml (2.3mmol/l) and 5.0ml (11.5mmol/l) of acetic acid added to the 7 liter of DI water. The implanted wafers are exposed to cleans with either 0 or 11.5 mmol/l of acetic acid added.

For implanted resist, removal efficiency is increased by about 50% (60nm/min versus 90nm/min) upon addition of the indicated quantity of acetic acid. Results for unimplanted resist are presented in Figure 9. A process efficiency number is defined, i.e. the resist removal efficiency normalized versus ozone concentration, and expressed as a removal rate per unit of process time. The as such defined process efficiency number increases from 0.8 till 1.2 nm/(min*ppm) for negative resist and from 4.5 till 8.5 nm/(min*ppm) for positive resist. Despite the order of magnitude difference for positive and negative resist removal, general trends are identical. It can be seen that a positive effect on the process efficiency number is generated from acetic acid addition.

### Application 3: Resist removal

Based on the above, experimentally designed trials are done. Effect under study is the resist removal efficiency by means of ozonated chemistries, with the use of chemical additives. Both positive and negative postbaked resist are studied. The O₃ reference set-up (immersion based), denoted as bubble experiment and presented in Figure 8 is used. In order to have a better assessment of the effect of the individual variables under evaluation, wafers were not exposed directly to the ozone bubbles. This lower ozone availability (no bubble or gas contact) is reflected in the lower removal rate and process efficiency number compared to application 2. Variables under consideration are acetic acid, hydrogenperoxide and ozone (by varying the oxygen flow) concentration, as well as temperature and pH of the solution. The effect of pH (varied between 2 and 5, HNO3 addition) is included to determine whether or not the impact of acetic acid is not induced by the changing pH. Hydrogenperoxide is added as it is a known OH radical generator. Quantities added are 0, 0.1 or 0.2 ml (Ashland, GB, 30%). Acetic acid (Baker, reagent grade, 99%) addition is either 0, 0.5 or 1 ml in 7 liter of DI water. Temperature was varied between 21 and 40°C, while O₃ concentration was controlled from the O₂ flow through the generator. Low flow is 3 l/min, high flow is 5l/min. Both for positive and negative resist removal, results are expressed as resist removal rate per unit of time. Experimental results are presented in Table I. RS/Discover is used to analyse the experimental results. This is done using a stepwise multiple regression according to a least squares method and a quadratic model. This model accounts for about 90% of the variation observed in the experimental results.

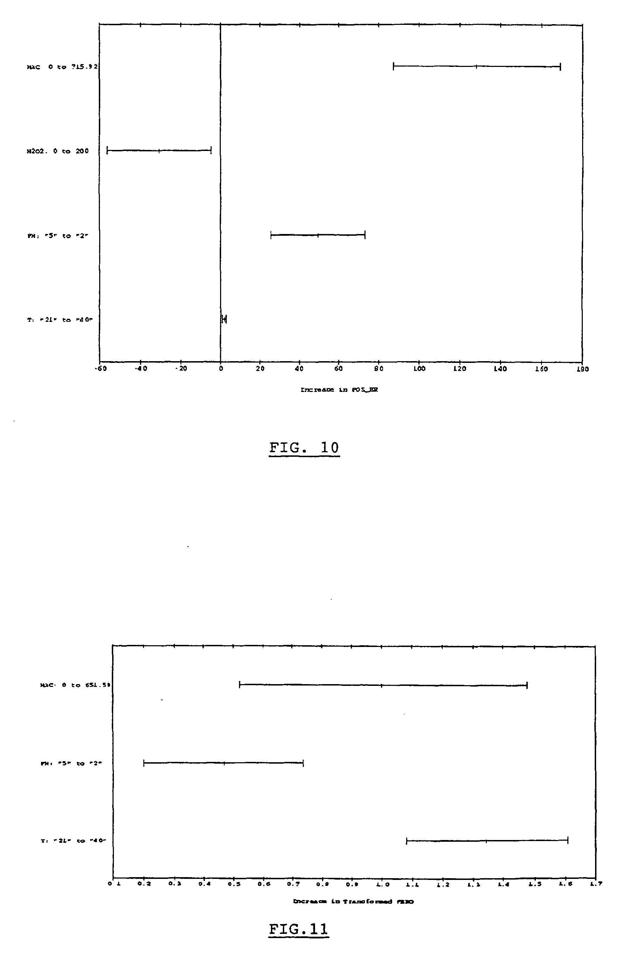

Only results for positive resist are presented in Figures 10 and 11, the statistics for negative resist removal are identical. The main effects on all of the responses is shown in Figure 10. Notice that the largest positive effect on resist removal is due to the change in acetic acid concentration (going from 0 till 715µl HAc addition), with pH being of far less importance. Also, the resist removal rate is reduced by the addition of hydrogenperoxide (going from 0 till 200µl). From this graph it could be concluded that the temperature is of little importance. However, the ozone concentration is strongly dependent on the temperature (solubility and stability relate inversely with temperature), which biases the results. Therefore, a process efficiency number is defined; i.e. the resist removal efficiency normalized versus ozone concentration and expressed as a removal rate per unit of time and per unit of ozone (i.e. nm / (min * ppm)). The as such obtained process efficiency number varies between 0.2 and 4nm/(min * ppm) for positive resist and 0.03 and 0.4 nm/(min * ppm) for negative resist. The outcome of the impact of the various parameters on the process efficiency number is plotted in Figure 11 for positive resist removal. Despite the order of magnitude difference between positive and negative resist removal, general trends are identical. It can be seen that a positive effect on the process efficiency number is generated from acetic acid addition, ozone concentration and temperature enhancement.

### Application 4: Resist removal

In a further study of the method of the present invention, another experiment is described hereunder, wherein no acetic acid is added to the solution.

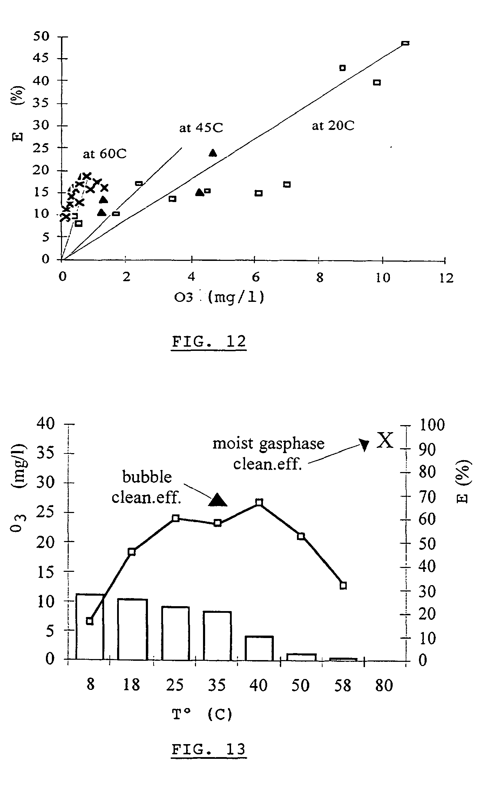

The main requirement for the ozonated chemistries is fast and complete removal of organic contaminants (e.g. clean room air components, photoresist or side-wall polymers). Critical parameters influencing the removal efficiency are to be identified. It was assessed above that acetic acid spiking influenced results, however also other parameters such as ozone concentration and temperature are likely important. Therefore, the impact of O₃ concentration and operational temperature for positive resist removal efficiency was evaluated experimentally. Wafers coated with a 5 nm thick photoresist coating were prepared and immersed in a static bath containing DI water (set-up as in Figure 8, but ozone bubbling off during immersion). Ozone concentration was varied between 0 and 12 ppm, and temperature between 20, 45 and 70°C. Purposely, 1 min cleans are done in static conditions (i.e. gas flow off, after 03 saturation of DI), to assess the parameter impact. Principal results are shown in Fig.12, where cleaning efficiency is plotted versus O₃ concentration for the three different temperature ranges. Removal is only 50% due to the small processing time and static conditions (limited ozone availability). It can be seen that cleaning efficiency per unit of ozone, is more performing at elevated temperatures, while total removal in the time frame studied is more performing at higher ozone concentration. However, O₃ solubility decreases with temperature, while process performance increases with temperature.

Ozone concentration in solution, and thus oxidizing capabilities and cleaning performance can be maximized relying on physical aspects. One process, described previously in US-A-5 464 480 operates the water at reduced temperature (chilled), in order to increase ozone solubility. Disadvantages are the lowered reactivity and longer process times due to reaction kinetics. Another possibility to improve the ozone concentration is using more efficient ozone generators and/or ozone diffusor systems to transfer ozone into the DI water. From the above observations however, it is believed that any optimized process should aim at maximizing the O₃ concentration at operating temperatures. This assumption is demonstrated with the set-ups shown in Fig.2 and 8, where both traditional immersion with bubble contact (at subambient, ambient and elevated temperatures) and a moist gasphase process (at elevated temperature) are presented. Description of both set-ups is given above. Positive resist wafers (1.2nm) are exposed for 10 min, at various temperatures (bubble), or at 80°C (gasphase). Results are shown in Figure 13. Dissolved O₃ concentration for bubble experiment (bar graph) and cleaning efficiency (line graph and cross) is shown. The cleaning behavior for the bubble experiment is understood from a process limited by kinetic factors in the low temperature range and by ozone solubility in the higher temperature range. The latter limitation is reduced for the moist ozone ambient experiment of the invention. By exposing the wafer to a moist atmosphere, a thin condensation layer is formed on the wafer. The O₃ gas ambient maintains a continuous high supply of O₃ (wt% O₃ in gas, ppm in solution). Also, the thin condensation layer reduces the diffusion limitation and allows the shortliving reactive O₃ components to reach the wafer surface, resulting in near 100% removal. Important to note is the fact that the gasphase process, in the absence of moist one is unsuccessful.

### Alternate embodiments and explication

### Ozone chemistry consideration

According to another plausible explanation of the result obtained by using the method involving ozone in aqueous solution is explained. Ozone decomposition in aqueous solutions is base catalyzed following either a radical (A) or ionic initiation mechanism (B).

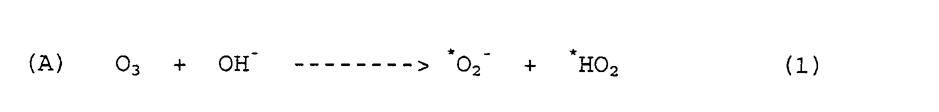

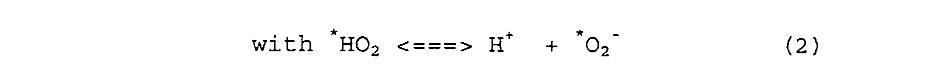

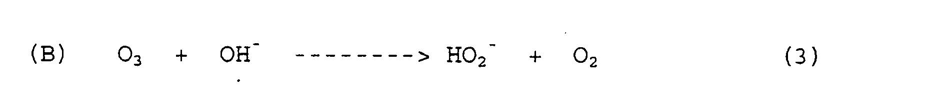

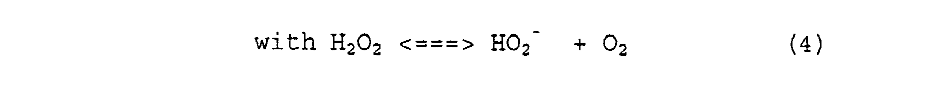

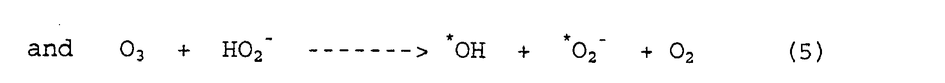

Further ozone decomposition occurs along reactions (6) and (7), independent of either type of initiation reaction. It can also be seen that despite the initiation mechanism, either ionic or radical, at least three ozone molecules decompose per unit of hydroxyl ions.

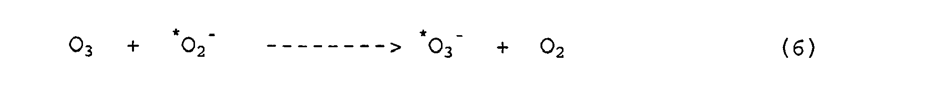

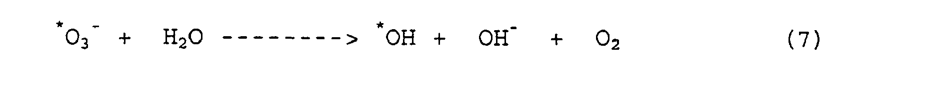

In addition to the above described ozone decomposition pathways, also the OH radicals (as formed in reaction (5) and (7)), initiate further ozone decomposition according to reaction pathway (8). Also, a chain type reaction is initiated if the reaction products are combined with reaction (2), (6) and (7).

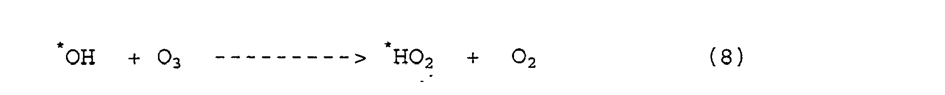

These decomposition mechanisms are a good model to explain the observed ozone depletion in neutral or caustic aqueous environment. However, in acid environment, the observed decomposition rate of ozone is faster than can be expected from the hydroxyl concentration, given reactions (1-4) . Therefore, an additional decomposition mechanism is required. This initiation mechanism is presented in equations (9-11), in combination with the earlier described reactions (2), (6) and (7).

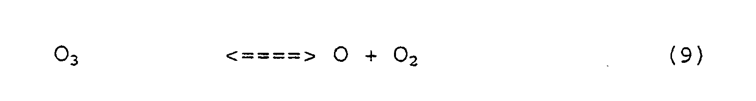

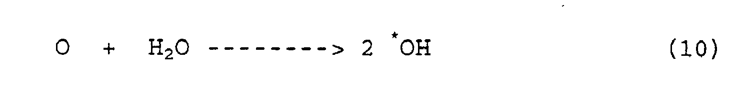

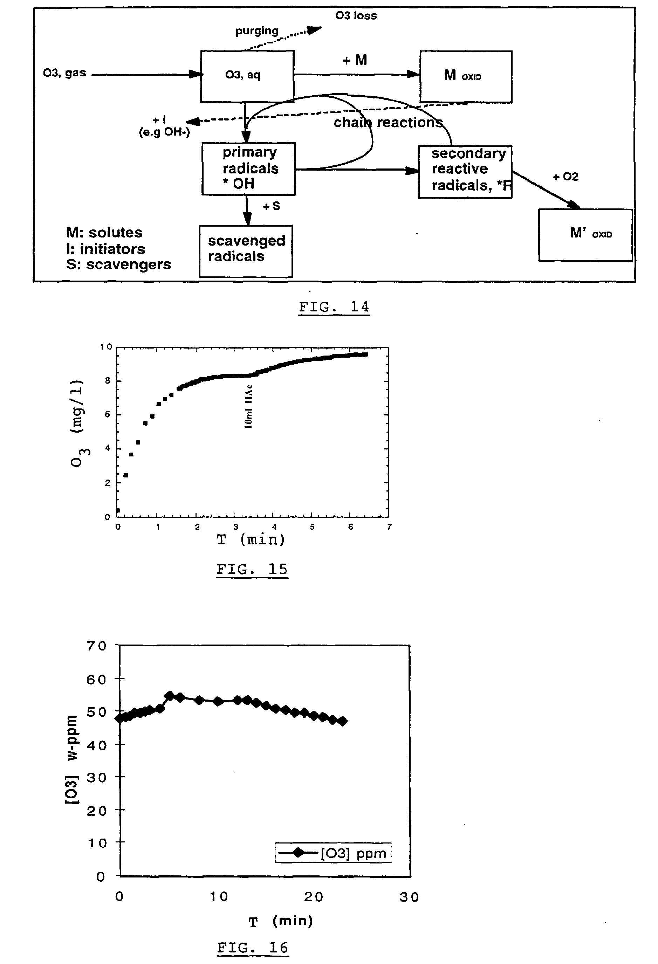

Reactions (1-10) describe the depletion of ozone in aqueous environment. However, in the presence of oxidizable components the situation becomes even more complex, and an overall picture is graphically presented in Figure 14. Transfer of ozone into aqueous solution is limited by the solubility, thus resulting in ozone loss through purging. The primary reaction is the consumption of ozone by solutes M that become oxidized. Among these reactions is also the oxidation of water to hydrogenperoxide (with resulting equilibrium H₂O₂<==>HO₂⁻ + H⁺). This primary reaction is often slow, therefore ozone is likely to decompose via alternative reaction pathways. As such, reaction between initiators I (OH⁻, HO₂⁻, ...) and ozone results in the formation of primary radicals (*OH), which may either become scavenged or react further with ozone to yield more free radicals or take part in the advanced oxidation pathway of solutes M. Referring to reactions (1-10) and Figure 14, it is anticipated that the ozone chemistry can also be controlled chemically, i.e. from selective addition of additives.

The influence of additives on the ozone chemistry as derived from the above, is demonstrated for an overflow bath whereby ozone/water mixtures are prepared in a Gore ozone module (membrane based type mixer) to reduce the presence of O₂/O₃ gas bubbles in the overflow bath. Water flow in the overflow bath (20 l/min),O₂ flow (2 l/min) through the ozone generator and pressure in the ozone module (1 bar) determine the achievable O₃ levels in the bath. These variables are kept constant at the indicated values for the experiments presented here. At all times the ozone level in DI water is allowed to saturate prior to the addition of any chemical. All chemicals used are Ashland GB grade apart acetic acid (99%) which is Baker reagent grade. To eliminate the influence of reaction kinetics, all experiments are performed at room temperature. An Orbisphere labs MOCA electrochemical ozone sensor is used for all ozone measurements.

As represented in Figure 15, the behavior of acetic acid on the ozone concentration in DI water in an overflow tank is considered by adding 10 ml acetic acid (99w%) to the DI water after saturation of the ozone level. Almost immediately, the ozone level starts to increase.

### Influence of acetic acid on the resist removal efficiency of ozonated chemistries.

Advanced oxidation processes rely on the presence of OH radicals which are the chain propagating radical in O3 decomposition (K. Sehested, H. Corfitzen, J. Holcman, E.Hart, J.Phys.Chem., 1992, 96, 1005-9). According to G.Alder and R.Hill in J.Am.Chem.Soc. 1950, 72, (1984), OH radicals are the main reason for decomposition of organic material. Commonly applied procedures in waste water treatment processes involve e.g. UV radiation, pH or addition of hydrogenperoxide. As such enhancement of OH radical formation is achieved.

Three different experiments using first a hydrogen peroxide, hydrogen peroxide added to acetic acid, and finally acetic acid alone are performed.

The effect of hydrogen peroxide spiking into the ozonated DI water on the removal efficiency of positive resist from silicon wafers can be seen in Table II. It should be noted that the concentration of hydrogen peroxide spiked is in the order of the actual ozone concentration in the DI water. It can be observed that spiking of a 50µl (Ashland GB, 30%) of H₂O₂ into an 7.5 1 tank (0.08 mmol/l) has a strong effect. The measured resist removal rate decreases by a factor of four. Further addition of H₂O₂ reduces the resist removal efficiency even further, until the removal process becomes practically unexisting (2 nm/min removal rate). This is contrary to the effects seen for waste water treatment, where enhanced OH radical availability results in improved removal rates for organic contamination. The organics to be removed in wastewater treatment are dispersed in the solution (as is ozone and OH radicals), while for our purposes, the organic contamination is confined in a layer covering at least part of the substrate. It is likely that for our purposes, not the total amount of `ozone and ozone based components' that is available in the solution, but rather the chemical activity that emerges in the vicinity of the confined layer of organic material near the wafer surface is of importance.

Therefore, in this application, the OH radical catalyzed ozone decomposition mechanism is controlled through scavenging of the OH radicals formed. A scavenger is a substance added to a mixture or other system to counteract the unwanted effects of other constituents. Acetic acid or acetate is a stabilizer of aqueous ozone solutions. In Figure 16, the combined effect of acetic acid and repeated hydrogenperoxide spiking (OH radical enhancer) on ozone concentration is demonstrated. Despite the spiking of H₂O₂ at time t=0 (0.17mmol/l), the ozone concentration does increase slightly further in case the DI water is stabilized with only 0.23mmol/l of acetic acid. Even after several H₂O₂ additions (each time 0.17mmol/l), the ozone level did not drop below the initial starting level. This confirms the robustness of the acetic acid in quenching the OH radical initiated chain decomposition of ozone.

Table III contains the experimental results for resist removal of a 10-minute process with ozonated DI water when minor amounts of acetic acid are added to the solution. The resist removal is recalculated for the 10 min process time and is expressed as a removal rate (in nm/min). It is worth noting that due to the experimental set-up, the measured ozone concentrations are purely qualitative (separation between ozone sensor and O₂/O₃ gas flow is not always reproducible). Adding between 0.02 mmol/l and 0.24 mmol/l of acetic acid to ozonated DI water, improves the resist removal efficiency by almost 50% compared to the unspiked reference process. The combined effect of acetic acid and hydrogen peroxide spiking is evaluated for resist removal purposes and shown in Table IV. In these runs, the DI water is initially spiked with 0.02 mmol/l of acetic acid, after ozone saturation, a variable concentration of hydrogen peroxide is added, and the effect on resist removal efficiency is evaluated. Adding of hydrogen peroxide in the presence of the acetic acid reduces the resist removal rate, though with far less strong consequences compared to the effect as seen in Table II. Also, it can be seen that the stabilizing effect induced from adding the acetic acid is stronger then observed for acidifying the solution (Table II, with HNO₃).

Higher ozone concentrations are achieved in DI water from the addition of acetic acid. However, the improvement in resist removal efficiency can not solely be explained from the increased ozone concentration upon addition of acetic acid. Figure 9 plotted impact of acetic acid addition on the resist removal process efficiency number, which is normalized for the ozone concentration. The process efficiency was seen to increse upon acetic acid addition. Therefore some other unknown mechanism is coming into play.

The organic material is confined in a layer at the silicon surface, rather than homogeneously dispersed in the solution as is the case for e.g. waste water treatment. Given the small lifetime of dissolved ozone (t1/2 = 20 min at room temperature) and reactive ozone species, transfer of waste water ozone knowledge is not feasable for our applications. For good organic removal, sufficient chemical activity (reactive O₃ availability) in the vicinity of the confined layer of organic material near the wafer surface is required. It has been seen that the removal efficiency of organic contamination on silicon wafers is strongly influenced by temperature, ozone concentration and addition of acetic acid. Temperature and ozone concentration requirements are met in the moist ozone gas phase experiment described above. By exposing the wafer to a moist atmosphere, a thin condensation layer is formed on the wafer surface. Due to the ozone gas phase ambient, a continuous supply of ozone compounds through the thin condensation layer, towards the organic contamination at the silicon surface, is maintained. Also in the bubble experiment, ozone containing bubbles continuously contact the confined layer of organic contamination.

However, the critical parameter as far as ozone concentration is concerned, is not solely the total amount of `ozone' that is available in the solution. It rather is the chemical activity that emerges in the vicinity of the confined layer of organic material near the wafer surface. In order for any ozone oxidation process to be successful, one should not necessary maximize the amount of ozone, but improve the transfer efficiency (or availability) of the ozone (molecular and radical) towards the organic contamination to be removed. The latter is likely achieved additionally from acetic acid addition.

Scavenging of OH radicals in oxygenated acetic acid solution leads to the formation of H₂O₂ via reactions described hereunder [K.Sehested et.al, Environ.Sci.Technol. 25, 1589, 1991].

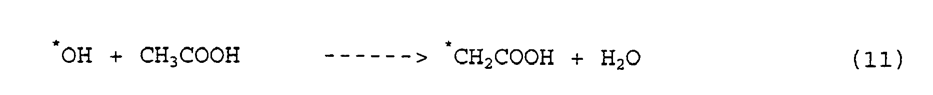

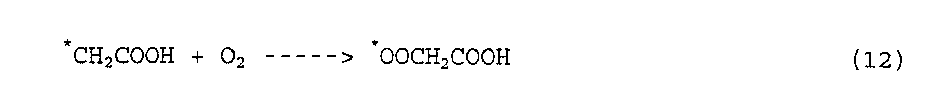

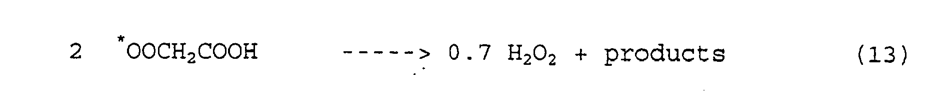

The other products formed in reaction (13) are formaldehyde, glyoxylic acid, glycolic acid and organic peroxides.

A reaction of the acetic free radical (reaction (11)), with the resist surface, might make the latter more reactive towards ozone. This could involve abstraction of an hydrogen atom, and formation of an unsaturated bond. This unsaturated bond would then be available for reaction with molecular ozone. Secondly, scavenging of free OH radicals very close to the resist surface. The resulting decomposition of acetic acid according to reactions (11-13) results in the formation of e.g. H₂O₂. Which in its turn could initiate the formation of controlled and localized 'advanced oxidation power' (OH radicals) very near to the resist surface.

**Table I: Designed experiment settings and results.**

| HAC | H₂O₂ | pH | O₂ | Temp. | Pos_er | Neg_er | [03]av |
|---|---|---|---|---|---|---|---|
| ml | ml | | flow | | nm/min | nm/min | ppm |
| 1 | 0 | 5 | hi | 40 | 51.2 | 7.36 | 18.2 |
| 1 | 0.2 | 2 | lo | 21 | 34.8 | 3.11 | 54.6 |
| 1 | 0.1 | 5 | hi | 40 | 40.1 | 5.97 | 17.2 |
| 1 | 0 | 5 | lo | 21 | 36.9 | 2.60 | 52.6 |
| 0 | 0.2 | 2 | lo | 40 | 19.3 | 0.02 | 14.5 |
| 1 | 0 | 2 | hi | 21 | 36.1 | 2.73 | 44.8 |
| 0 | 0.2 | 5 | lo | 21 | 3.4 | 0.39 | 14.7 |
| 0.5 | 0 | 5 | hi | 40 | 36.3 | 5.91 | 17.1 |
| 0 | 0.2 | 5 | hi | 40 | 4.6 | 1.32 | 5.7 |
| 1 | 0.2 | 5 | lo | 40 | 31.9 | 5.98 | 17.9 |
| 0 | 0 | 2 | lo | 21 | 33.1 | 1.46 | 47.6 |
| 0 | 0.2 | 2 | hi | 21 | 26.8 | 1.96 | 37.9 |
| 0 | 0 | 5 | hi | 21 | 27.0 | 2.58 | 39.8 |
| 0 | 0.1 | 2 | hi | 40 | 20.7 | 2.62 | 11.4 |
| 0 | 0 | 2 | hi | 40 | 31.6 | 3.34 | 15.6 |
| 1 | 0.2 | 5 | hi | 21 | 31.4 | 2.85 | 44.7 |
| 1 | 0.2 | 2 | hi | 40 | 55.9 | 3.78 | 15.9 |
| 1 | 0. | 2 | lo | 40 | 41.8 | 3.96 | 17.7 |
| 0.5 | 0.1 | 5 | hi | 21 | 36.6 | 3.26 | 42.4 |
| 0.5 | 0.2 | 5 | lo | 40 | 37.0 | 2.93 | 15.1 |
| 0.5 | 0.2 | 2 | hi | 40 | 47.3 | 3.22 | 14.4 |
| 0 | 0 | 5 | lo | 40 | 11.9 | 1.24 | 13.6 |
| 1 | 0.1 | 2 | lo | 21 | 34.4 | 1.89 | 49.9 |

**Table II: Effect of hydrogenperoxide on resist removal efficiency.**

| **[O₃]** | **H₂O₂ added** | **HNO₃ added** | **Resist removal** |
|---|---|---|---|
| **average** | **(ml)** | **(ml)** | **(nm/min)** |
| **w-ppm** | | | |
| *48.0* | 0 | 0 | 38.4 |
| *37.0* | 0.05 | 5.5 | 11.3 |
| *30.9* | 0.05 | 0 | 9.3 |
| *24.7* | 0.1 | 0 | 7.7 |
| *4.5* | 0.5 | 0 | 2.1 |

**Table III: Effect of acetic acid on resist removal efficiency**

| **[O₃]** | **H₂O₂ added** | **HAc** | **Resist removal** |
|---|---|---|---|
| **average** | **(ml)** | **added** | **(nm/min)** |
| **w-ppm** | | **(ml)** | |
| *48.0* | 0 | 0 | 38.4 |
| *49.5* | 0 | 0.1 | 47.1 |
| *50.0* | 0 | 1.1 | 51.1 |
| *54.3* | 1 | 1.1 | 34.2 |

**Table IV: Effect of acetic acid and hydrogen peroxide on resist removal efficiency.**

| **[O₃]** | **H₂O₂ added** | **HAc** | **Resist removal** |
|---|---|---|---|
| **average** | **(ml)** | **added** | **(nm/min)** |
| **w-ppm** | | **(ml)** | |
| *49.5* | 0 | 0.1 | 47.1 |
| *45.6* | 0.1 | 0.1 | 21.9 |
| *38.6* | 0.2 | 0.1 | 18.1 |
| *46.0* | 1.5 | 0.1 | 22.3 |

## Claims

1. A method for removing organic contaminants from a substrate comprising the steps:
holding said substrate in a tank;
adding to said tank a gas mixture comprising water vapor, ozone and an additive acting as an OH radical scavenger, and wherein the temperature of said mixture is below 150°C but higher than the temperature of said substrate,
performing a contact between said substrate and said gas mixture whereby a thin condensation layer is formed on the substrate.

2. A method as recited in claim 1, wherein the proportion of said additive in said gas mixture is less than 10% molar weight of said gas mixture.

3. A method as recited in claim 1, wherein the proportion of said additive in said gas mixture is less than 1% molar weight of said gas mixture or said liquid

4. A method as recited in claim 1, wherein the proportion of said additive in said gas mixture is less than 0.5% molar weight of said gas mixture or said liquid.

5. A method as recited in claim 1, wherein the proportion of said additive in said gas mixture is less than 0.1% molar weight of said gas mixture or said liquid.

6. A method as recited in claim 1, wherein the ozone concentration in the gas mixture is less than 10% molar weight of said mixture.

7. A method as recited in claim 1, further comprising the steps of adding oxygen or nitrogen or argon to said mixture.

8. A method as recited in claim 1, said method comprising the steps of:
REPLACEMENT PAGE
adding to said tank a liquid comprising water and said additive, the liquid level in said tank remaining below said substrate; and
heating said liquid.

9. A method as recited in any one of the preceding claims, wherein the organic contaminant is confined in a layer covering at least part of said substrate.

10. A method as recited in claim 9, wherein said layer has a thickness in the range of submonolayer coverage and 1µm.

11. A method as recited in any one of the preceding claims, wherein said additive is a carboxylic or a phosphonic acid or salts thereof.

12. A method as recited in any one of the claims 1 to 10, wherein said additive is acetic acid.

13. A method as recited in any one of the preceding claims, further comprising the steps of rinsing said substrate with a solution.

14. A method as recited in claim 13, wherein said rinsing solution comprises de-ionised water.

15. A method as recited in claim 14, wherein said rinsing solution further comprises HCl and/or HF and/or HN03 and/or CO2 and/or 03.

16. A method as recited in any one of the preceding claims, wherein said substrate is a silicon wafer.

## Patentansprüche

1. Verfahren zum Entfernen organischer Kontaminationen von einem Trägermaterial, welches die folgenden Schritte umfasst:
bereithalten des Trägermaterials in einem Tank;
hinzufügen eines Gasgemischs zu dem Tank das Wasserdampf, Ozon und ein Zusatzmittel,welches als OH-Radikalfänger wirkt, enthält und wobei die Temperatur des Gasgemischs unterhalb von 150 °C aber höher als die Temperatur von dem Trägermaterial liegt,
ausführen eines Kontaktes zwischen dem Trägermaterial und dem Gasgemisch, wobei eine dünne Kondensationsschicht auf dem Trägermaterial gebildet wird.

2. Verfahren nach Anspruch 1, wobei der Anteil des Zusatzmittels in dem Gasgemisch weniger als 10 % der molaren Masse des Gasgemischs beträgt.

3. Verfahren nach Anspruch 1, wobei der Anteil des Zusatzmittel in dem Gasgemisch weniger als 1 % der molaren Masse des Gasgemischs oder der Flüssigkeit beträgt.

4. Verfahren nach Anspruch 1, wobei der Anteil des Zusatzmittels in dem Gasgemisch weniger als 0,5 % der molaren Masse des Gasgemischs oder der Flüssigkeit beträgt.

5. Verfahren nach Anspruch 1, wobei der Anteil des Zusatzmittels in dem Gasgemisch weniger als 0,1 % der molaren Masse des Gasgemischs oder der Flüssigkeit beträgt.

6. Verfahren nach Anspruch 1, wobei die Ozonkonzentration in dem Gasgemisch weniger als 10 % der molaren Masse des Gasgemischs beträgt.

7. Verfahren nach Anspruch 1, das ferner die Schritte des Hinzufügens von Sauerstoff oder Stickstoff oder Argon zu dem Gemisch umfasst.

8. Verfahren nach Anspruch 1, wobei das Verfahren die folgenden Schritte umfasst:
hinzufügen von einer Flüssigkeit zu dem Tank die Wasser und das Zusatzmittel enthält, wobei der Flüssigkeitsspiegel in dem Tank unterhalb des Trägermaterials bleibt; und
erhitzen der Flüssigkeit.

9. Verfahren nach einem der vorangehenden Ansprüche, wobei die organische Kontamination in einer Schicht eingeschlossen ist die mindestens einen Teilbereich des Trägermaterials bedeckt.

10. Verfahren nach Anspruch 9, wobei die Schicht eine Dicke in dem Bereich von einer sub-monoschicht Bedeckung bis zu 1 µm aufweist.

11. Verfahren nach einem der vorangehenden Ansprüche, wobei das Zusatzmittel eine Carbonsäure oder eine Phosphonsäure oder Salze davon ist.

12. Verfahren nach einem der Ansprüche 1 bis 10, wobei das Zusatzmittel Essigsäure ist.

13. Verfahren nach einem der vorangehenden Ansprüche, das ferner den Schritt des Spülens von dem Trägermaterial mit einer Lösung umfasst.

14. Verfahren nach Anspruch 13, wobei die Spüllösung entionisiertes Wasser umfasst.

15. Verfahren nach Anspruch 14, wobei die Spüllösung ferner HCl und/oder HF und/oder HNO₃ und/oder CO₂ und/oder O₃ enthält.

16. Verfahren nach einem der vorangehenden Ansprüche, wobei das Trägermaterial eine Siliziumscheibe ist.

## Revendications

1. Procédé d'élimination de contaminants organiques d'un substrat comprenant les étapes consistant à :
maintenir ledit substrat dans un réservoir ;
ajouter audit réservoir un mélange de gaz comprenant de la vapeur d'eau, de l'ozone et un additif agissant comme un capteur de radicaux OH, et dans lequel la température dudit mélange est inférieure à 150 °C, mais supérieure à la température dudit substrat,
réaliser un contact entre ledit substrat et ledit mélange de gaz, par lequel une fine couche de condensation est formée sur le substrat.

2. Procédé selon la revendication 1, dans lequel la proportion dudit additif dans ledit mélange de gaz est inférieure à 10 % en poids molaire dudit mélange de gaz.

3. Procédé selon la revendication 1, dans lequel la proportion dudit additif dans ledit mélange de gaz est inférieure à 1 % en poids molaire dudit mélange de gaz ou dudit liquide.

4. Procédé selon la revendication 1, dans lequel la proportion dudit additif dans ledit mélange de gaz est inférieure à 0,5 % en poids molaire dudit mélange de gaz ou dudit liquide.

5. Procédé selon la revendication 1, dans lequel la proportion dudit additif dans ledit mélange de gaz est inférieure à 0,1 % en poids molaire dudit mélange de gaz ou dudit liquide.

6. Procédé selon la revendication 1, dans lequel la concentration en ozone dans le mélange de gaz est inférieure à 10 % en poids molaire dudit mélange.

7. Procédé selon la revendication 1, comprenant en outre les étapes consistant à ajouter de l'oxygène ou de l'azote ou de l'argon audit mélange.

8. Procédé selon la revendication 1, ledit procédé comprenant les étapes consistant à :
ajouter audit réservoir un liquide comprenant de l'eau et ledit additif, le niveau de liquide dans ledit réservoir demeurant sous ledit substrat ; et
chauffer ledit liquide.

9. Procédé selon l'une quelconque des revendications précédentes, dans lequel le contaminant organique est confiné dans une couche recouvrant au moins une partie dudit substrat.

10. Procédé selon la revendication 9, dans lequel ladite couche a une épaisseur dans la plage de la couverture de sous-monocouche et 1 µm.

11. Procédé selon l'une quelconque des revendications précédentes, dans lequel ledit additif est un acide carboxylique ou phosphonique ou des sels de ceux-ci.

12. Procédé selon l'une quelconque des revendications 1 à 10, dans lequel ledit additif est l'acide acétique.

13. Procédé selon l'une quelconque des revendications précédentes, comprenant en outre les étapes consistant à rincer ledit substrat avec une solution.

14. Procédé selon la revendication 13, dans lequel ladite solution de rinçage comprend de l'eau désionisée.

15. Procédé selon la revendication 14, dans lequel ladite solution de rinçage comprend en outre du HCl et/ou HF et/ou HN03 et/ou CO2 et/ou 03.

16. Procédé selon l'une quelconque des revendications précédentes, dans lequel ledit substrat est une tranche de silicium.
